# EUROPÄISCHE PATENTANMELDUNG

(11) **EP 0 849 875 A1**
(43) Veröffentlichungstag der Anmeldung: **24.06.1998**
(21) Anmeldenummer: 97122319.3
(22) Anmeldetag: 17.12.1997
(51) Int. Cl.: H03F 1/30, H03F 3/217

(54) **Analogsignal-Rechtecksignal-Umformvorrichtung mit Offset-Kompensation**

(30) Priorität: 19.12.1996 DE 19653189
(71) Anmelder: SGS-THOMSON MICROELECTRONICS GMBH, 85630 Grasbrunn (DE)
(72) Erfinder: Roither, Gerhard, 81827 München (DE); Hackl, Günther, 84503 Altötting (DE); Fischer, Uwe, 82008 Unterhaching (DE)
(74) Vertreter: Klunker . Schmitt-Nilson . Hirsch

(57) **Zusammenfassung**

Analogsignal-Rechtecksignal-Umformvorrichtung zur schwellenwertabhängigen Umformung eines analogen Eingangssignals in ein Rechtecksignal;
mit einer offset-behafteten Umformschaltung (COM) mit einem Signaleingang (SE), dem das analoge Eingangssignal (AS) zuführbar ist, einem Referenzeingang (RE), dem eine die Umformschwelle bestimmende Referenzspannung zuführbar ist, und einem Signalausgang (CA), von dem das Rechtecksignal (RS) abnehmbar ist;
mit einer Offset-Speichereinrichtung (C), die mit dem Signaleingang (SE) der Umformschaltung (COM) verbunden ist und in der eine der Offsetspannung der Umformschaltung (COM) entsprechende Ladespannung speicherbar ist, die dem analogen Eingangssignal zur Offset-Kompensation überlagerbar ist;
mit einer steuerbaren Schaltereinrichtung (S), welche in einem ersten Schaltzustand die Umformfunktionsweise der Umformschaltung (COM) unbeeinflußt läßt und zum Zweck der Offset-Kompensation in einem zweiten Schaltzustand den Umformvorgang der Umformschaltung (COM) unterbricht und eine Aufladung der Offset-Speicher-Einrichtung (C) auf die der jeweiligen Offset-Spannung entsprechende Ladespannung bewirkt;
mit einer Detektoreinrichtung (DET), mittels welcher mindestens näherungsweise zu denjenigen Zeitpunkten ein Detektionssignal erzeugbar ist, zu welchen das analoge Eingangssignal (AS) einen vorbestimmten Detektionsschwellenwert durchläuft;
mit einer Verzögerungseinrichtung (MF1) mittels welcher das Detektionssignal um eine vorbestimmte Verzögerungszeitdauer (TD) verzögerbar ist;
und mit einer Schaltersteueranordnung (MF2, SSE), mittels welcher beim Auftreten des verzögerten Detektionssignals die Schaltereinrichtung (S) für eine vorbestimmte Fensterzeitdauer (TF) in den zweiten Schaltzustand steuerbar ist;
wobei die Fensterdauer (TF) zwischen den Flanken des Rechtecksignals (RS) liegt.

## Beschreibung

Die Erfindung betrifft eine Umformvorrichtung zur schwellenwertabhängigen Umformung eines analogen Eingangssignals in ein Rechtecksignal. Eine derartige Umformung wird beispielsweise im Zusammenhang mit Pulsbreitenmodulation, RDS-Biphasendemodulation (RDS=Radio Data System), Umwandlung von Sinuswellen in Rechteckwellen und ganz allgemein ausgedrückt bei der rechteckförmigen Begrenzung von Analogsignalen eingesetzt. Für derartige Umformschaltungen sind vorbestimmte Schwellenwerte als Diskriminationsschwellen für die Entscheidung, ob das Rechtecksignal einen hohen oder einen niedrigen Signalwert aufweist, erforderlich. Derartige Diskriminationsschwellen werden üblicherweise mit Hilfe von Komparatoren erzeugt, die allerdings offset-behaftet sind, was zu einer Verfälschung der Diskriminationsschwelle führt. CMOS-Komparatoren, die insbesondere für monolithisch integrierte Halbleiterschaltungen gerne verwendet werden, weisen besonders hohe Offset-Spannungen auf, verursachen daher eine besonders starke Verfälschung der Diskriminationsschwelle.

Sollen beispielsweise sinus- oder dreieckförmige Analogsignale schwellenabhängig in Rechtecksignale umgewandelt werden, bewirkt die Offset-Spannung eines solchen Komparators praktisch eine Verschiebung der Diskriminationsschwelle, was eine Veränderung der Rechteckimpulslängen gegenüber dem Fall bewirkt, in welchem die gewünschte Diskriminationsschwelle unverfälscht zur Verfügung steht. Beispielsweise in Zusammenhang mit Pulsbreitenmodulation oder der empfängerseitigen Verarbeitung von RDS-Radio-Signalen ist eine solche Impulsbreitenverfälschung höchst unerwünscht.

Es ist daher Aufgabe der Erfindung, eine Analogsignal-Rechtecksignal-Umformeinrichtung zu schaffen, deren Umform- oder Diskriminationsschwelle durch einen Offset-Fehler der verwendeten Umformschaltung nicht verfälscht wird.

Eine Lösung dieser Aufgabe ist im Anspruch 1 angegeben. Ausführungsformen der Erfindung geben die abhängigen Ansprüche an.

Demnach besteht die Erfindung in einer Umformvorrichtung zur schwellenwertabhängigen Umformung eines analogen Eingangssignals in ein Rechtecksignal; mit einer offset-behafteten Umformschaltung mit einem Signaleingang, dem das analoge Eingangssignal zuführbar ist, einem Referenzeingang, dem eine die Umform- oder Diskriminationsschwelle bestimmende Referenzspannung zuführbar ist, und einem Signalausgang, von dem das Rechtecksignal abnehmbar ist; mit einer Offset-Speicherkapazität, die mit dem Signaleingang der Umformschaltung verbunden ist und in der eine der Offsetspannung der Umformschaltung entsprechende Ladespannung speicherbar ist, die dem analogen Eingangssignal zur Offsetkompensation überlagerbar ist; mit einer steuerbaren Schaltereinrichtung, welche in einem ersten Schaltzustand die Umformfunktionsweise der Umformschaltung unbeeinflußt läßt und zum Zweck der Offset-Kompensation in einem zweiten Schaltzustand den Umformvorgang der Umformschaltung unterbricht und eine Aufladung der Offset-Speicherkapazität auf die der jeweiligen Offset-Spannung entsprechende Ladespannung bewirkt; mit einer Detektoreinrichtung, mittels welcher mindestens näherungsweise zu denjenigen Zeitpunkten ein Detektionssignal erzeugt ist, zu welchem das analoge Eingangssignal einen vorbestimmten Detektionsschwellenwert durchläuft; mit einer Verzögerungseinrichtung, mittels welcher das Detektionssignal um eine vorbestimmte Zeitdauer verzögerbar ist; und mit einer Schaltersteuereinrichtung, mittels welcher beim Auftreten des verzögerten Detektionssignals die Schaltereinrichtung für eine vorbestimmte Fensterzeitdauer in den zweiten Schaltzustand steuerbar ist; wobei die Fensterdauer zwischen den Flanken des Rechtecksignals liegt.

Bei der erfindungsgemäßen Umformvorrichtung werden Vorgänge zur Offset-Messung und zur Speicherung des gemessenen Offset-Wertes in der Offset-Speicherkapazität während solcher Zeitabschnitte durchgeführt, während welcher das aus der Umformung hervorgegangene Rechtecksignal seinen Amplitudenwert nicht ändert und somit kein Informationsverlust auftritt.

Bei einer bevorzugten Ausführungsform wird während der Zeitfenster, während welcher die Offset-Messung und -Speicherung durchgeführt wird, der vor Beginn des Zeitfensters vorhandene Signalwert des Rechtecksignals mittels einer Zwischenspeicher- oder Sample-and-Hold-Schaltung zwischengespeichert, so daß ein an die Umformvorrichtung angeschlossener Verbraucher von dem Offset-Meß- und Speichervorgang überhaupt nichts wahrnimmt.

Bei einer Ausführungsform der Erfindung weist die Umformschaltung einen offset-behafteten Komparator auf und umfaßt die Schaltereinrichtung einen zwischen den Signaleingang und den Signalausgang des Komparators geschalteten Schalter, der im ersten Schaltzustand nicht-leitend und im zweiten Schaltzustand leitend gesteuert ist. Bei dieser Ausführungsform ist die Offset-Speicherkapazität in Serienschaltung zwischen den Ausgang einer das analoge Eingangssignal liefernden Eingangssignalquelle und den Signaleingang des Komparators geschaltet.

Bei einer Ausführungsform der Erfindung weist die Umformvorrichtung zwei monostabile Kippschaltungen auf, von denen eine erste einen Verzögerungsimpuls und die zweite einen Zeitfensterimpuls liefert. Die erste Kippschaltung wird durch das Detektionssignal gesetzt, während die zweite Kippschaltung von der Impulsflanke am Ende des Verzögerungsimpulses gesetzt wird. Dabei wird die Schaltereinrichtung während der Dauer des Zeitfensterimpulses in den zweiten Schaltzustand gesteuert.

Bei Verwendung der erfindungsgemäßen Umformvorrichtung in einem RDS-Radio-Empfangsgerät erfolgt mittels der Umformvorrichtung eine Umformung der ohne RDS-Träger mit dem Sendesignal übertragenen, im Empfänger als Analogsignal ankommenden RDS-Komponente in ein Rechtecksignal, das einer RDS-PLL-Schaltung zur empfängerseitigen Wiedergewinnung des RDS-Trägers zugeführt wird. Mittels der Detektionseinrichtung werden die Nulldurchgänge des wiedergewonnenen RDS-Signals detektiert und werden mit Hilfe der Verzögerungseinrichtung und der Schaltersteuereinrichtung Zeitfenster nach der vorbestimmten Verzögerung gegenüber den Nulldurchgängen erzeugt. Auch hier können für die Erzeugung von Verzögerung und Zeitfenster je eine monostabile Kippschaltung verwendet werden.

Die Erfindung wird nun anhand von Ausführungsformen näher erläutert. In den Zeichnungen zeigen:
- **Fig. 1**: eine Ausführungsform einer erfindungsgemäßen Analogsignal-Rechtecksignal-Umformvorrichtung;
- **Fig. 2**: eine Ausführungsform einer im Zusammenhang mit Fig. 1 verwendbaren Verzögerungs- und Schaltersteuereinrichtung;
- **Fig. 3**: Signalverläufe zur Erläuterung der Analogsignal-Rechteck-Signalumformung mit und ohne Offset-Fehler; und
- **Fig. 4**: eine Darstellung einer Sinussignal-Rechtecksignal-Umformung mit Verzögerungs- und Zeitfensterimpulsen.

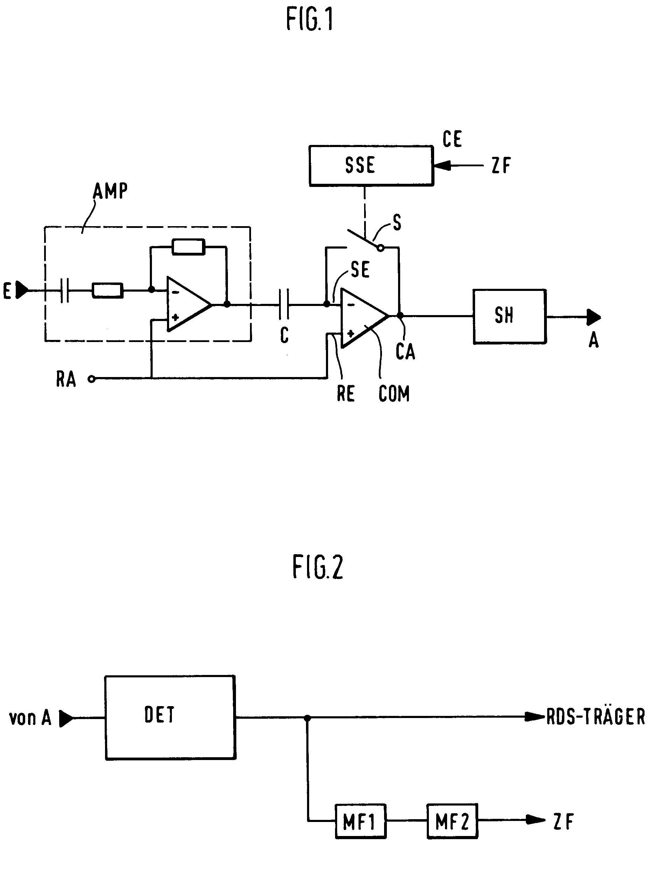

Die in Fig. 1 gezeigte Schaltungsanordnung umfaßt einen Analogsignalverstärker AMP mit an sich bekanntem und daher nicht näher erläutertem Aufbau. Einem Signaleingang E wird ein Analogsignal zugeführt, das nach Verstärkung mittels AMP über einen Kondensator C auf einen invertierenden Signaleingang SE eines offset-behafteten Komparators COM gegeben wird. Ein nicht invertierender Referenzeingang RE ist mit einem Referenzspannungsanschluß RA verbunden, dem die sogenannte Mittenspannung zugeführt wird, die bei üblichen integrierten Schaltungen mit einer Versorgungsspannung von + 5 V bei + 2,5 V liegt. Dieser Spannungswert von + 2,5 V liegt normalerweise auch als Gleichspannungswert auf der Verbindungsstrecke zwischen dem Ausgang des Verstärkers AMP und dem Signaleingang SE des Komparators COM.

Zwischen dem Signaleingang SE des Komparators COM und einem Komparatorausgang CA ist ein Schalter S geschaltet, dessen Schaltzustand mittels einer Schaltersteuereinrichtung SSE steuerbar ist. Der Komparatorausgang CA ist auf eine Zwischenspeicher- oder Sample-and-Hold-Schaltung SH geführt, deren Ausgang den Ausgang A der Analogsignal-Rechtecksignal-Umformvorrichtung bildet. Die Schaltsteuereinrichtung SSE weist einen Steuereingang CE auf, über welchen sie Zeitsteuersignale erhält.

Ist der Schalter S in einen offenen oder nicht-leitenden Zustand geschaltet, befindet sich der Komparator COM im Komparatorbetrieb. Ist der Schalter S in seinen leitenden Zustand gesteuert, ist der Komparatorbetrieb von COM außer Betrieb gesetzt und kann eine Messung der Offset-Spannung des Komparators COM durchgeführt werden.

Wäre der Komparator COM offsetfrei, würde dann, wenn das seinem Signaleingang SE zugeführte analoge Eingangssignal von einem Wert unterhalb 2,5 V auf einen Wert oberhalb 2,5 V ansteigt, am Ausgang CA des Komparators COM zu dem Zeitpunkt, zu welchem das analoge Eingangssignal den Mittenspannungswert + 2,5 V durchläuft, ein Potentialwechsel von einem hohen Potential zu einem niedrigen Potential auftreten. Weist der Komparator eine Offsetspannung auf, beispielsweise von + 10 mV, findet der Potentialwechsel am Komparatorausgang CA erst dann statt, wenn das analoge Eingangssignal am Signaleingang SE des Komparators COM den Spannungswert + 2,51 V durchläuft.

Zur Vorbereitung eines Offset-Kompensationsvorgangs wird der Schalter S leitend gesteuert. Wäre der Komparator COM offsetfrei, würde sowohl an seinen beiden Eingängen SE und RE als auch an seinem Ausgang CA der Mittenspannungswert + 2,5 V anliegen. Aufgrund des Offset-Fehlers des Komparators COM tritt aber an seinem Signaleingang SE ein anderer Spannungswert auf, bei dem zuvor angenommenen Beispiel ein Spannungswert von + 2,51 V, also ein Spannungswert, der um 10 mV höher ist als der Mittenspannungswert. Da sich die zum Verstärker AMP weisende Seite des Kondensators C auf der Mittenspannung + 2,5 V befindet, die zum Signaleingang SE des Komparators COM weisende Seite des Kondensators C dagegen auf dem durch die Offset-Spannung erhöhten Spannungswert + 2,51 V, wird der Kondensator C auf die Spannungsdifferenz + 10 mV aufgeladen, also genau auf die Offsetspannung des Komparators COM. Wird der Schalter S nach dem Abschluß des Offset-Meß- und Speichervorgangs wieder nicht-leitend gesteuert, wird dem dann dem Steuereingang SE von COM zugeführten analogen Eingangssignal der im Kondensator C gespeicherte Gleichspannungswert von 10 mV überlagert. Hat beispielsweise das analoge Ausgangssignal des Verstärkers AMP den Spannungswert + 2,5 V erreicht, der noch nicht zum Umschalten des Ausgangspotentials des Komparators COM ausreichen würde, wird diesem Analogsignalwert der im Kondensator C gespeicherte Offsetspannungswert überlagert, so daß zu diesem Zeitpunkt dem Steuereingang SE des Komparators COM der entsprechend erhöhte Spannungswert + 2,51 V zugeführt wird, was zum Kippen des Ausgangspotentials des Komparators COM führt.

Der Kondensator C hat somit die Funktion eines Speichers für die Offset-Spannung des Komparators COM.

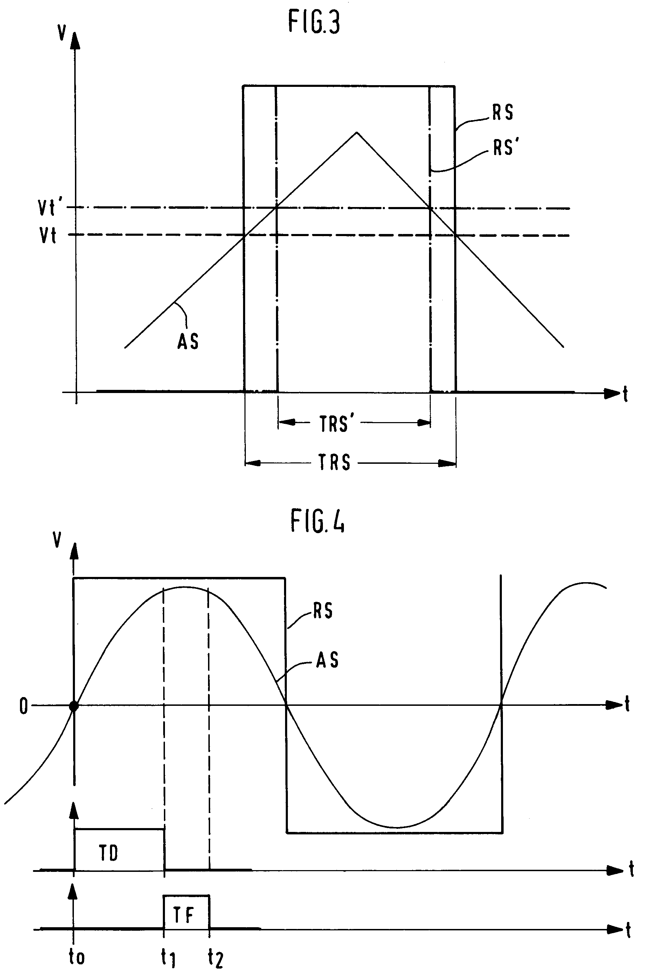

Anhand der Fig. 3 und 4 werden nun die Offset-Einflüsse bei der Analogsignal-Rechtecksignal-Umformung bzw. die Zeitsteuerung bei der erfindungsgemäßen Offset-Kompensationsmethode betrachtet.

Fig. 3 zeigt als Beispiel ein dreieckförmiges Analogsignal AS, das unter Verwendung eines gestrichelt dargestellten Spannungsschwellenwertes Vt als Diskriminationsschwelle in ein mit durchgezogenen Linien dargestelltes Rechtecksignal RS umgeformt werden soll. Bei korrekter Diskriminationsschwelle weist der in Fig. 3 gezeigte Impuls des Rechtecksignals RS eine Zeitdauer TRS auf.

Ein Offsetfehler des Komparators COM wirkt sich wie eine Verschiebung der Diskriminationsschwelle aus, so, als ob die Umformung mit einem strichpunktiert dargestellten Spannungsschwellenwert Vt' vorgenommen würde. Mit einer derartigen offset-verfälschten Diskriminationsschwelle erhält man das strichpunktiert dargestellte Rechtecksignal RS' mit einer Rechteckimpulslänge TRS'.

Der Abstand zwischen Vt und Vt' entspricht der Offsetspannung Voffset des Komparators COM.

Erfindungsgemäß werden eine Offset-Spannungsmessung und eine Offset-Spannungsspeicherung während eines Zeitfensters durchgeführt, das sich zwischen benachbarten Flanken des umgeformten Rechtecksignals befindet, und zwar in einem vorbestimmten Abstand von jeder dieser beiden Flanken. Dies erreicht man mittels einer in Fig. 2 dargestellten Schaltungsanordnung, die einen Detektor DET aufweist, der dann ein Detektionssignal abgibt, wenn das Analogsignal einen bestimmten Detektionsschwellenwert durchläuft. Dies kann beispielsweise der Nulldurchgang des Analogsignals sein. Bei Feststellung des Detektionsschwellenwertes erzeugt der Detektor DET ein Detektionssignal, das einer Reihenschaltung aus einer ersten monostabilen Kippschaltung MF1 und einer zweiten monostabilen Kippschaltung MF2 zugeführt wird. MF1 erzeugt einen Verzögerungsimpuls mit einer Verzögerungsimpulsdauer TD, während MF2 einen Zeitfensterimpuls mit einer Zeitfensterdauer TF erzeugt. Der Zeitfensterimpuls ZF wird dem Steuereingang CE der Schaltsteuereinrichtung SSE in Fig. 1 zugeführt. Während der Zuführung des Zeitfensterimpulses steuert die Schaltersteuereinrichtung SSE den Schalter S in den leitenden Zustand.

Dies ist in Fig. 4 im Zusammenhang mit der Umformung eines sinusförmigen Analogsignals AS in ein Rechtecksignal RS mit einer Diskriminationsschwelle von 0 V gezeigt. Dabei ist angenommen, daß der Detektor DET die Nulldurchgänge detektiert, also die Zeitpunkte, zu welchen das Analogsignal AS den Spannungswert 0 V durchläuft. Dieser Zeitpunkt ist in Fig. 4 mit t0 bezeichnet.

Zum Zeitpunkt t0 erzeugt der Detektor DET daher ein nicht dargestelltes Detektionssignal, das einen bis t1 dauernden Verzögerungsimpuls erzeugt. Dessen Ende bei t1 löst den bis t2 dauernden Zeitfensterimpuls aus, der zur Folge hat, daß der Schalter S zwischen t1 und t2 leitend geschaltet wird. Wie Fig. 4 zeigt, tritt der Zeitfensterimpuls während einer Zeit auf, während welcher sich der Signalwert des Rechtecksignals RS nicht ändert. Mit Hilfe der Zwischenspeicherschaltung SH wird für den an den Ausgang A angeschlossenen (nicht dargestellten) Verbraucher der vor t1 existierende Signalwert des Rechtecksignals RS aufrechterhalten. Die Zeitfensterdauer TF braucht nicht länger zu sein als die Zeit, welche zur Messung des Offset-Wertes von COM und zu dessen Speicherung im Kondensator C erforderlich ist.

Der Offset-Meß- und Speichervorgang muß nicht unbedingt während eines jeden Rechteckimpulses des Rechtecksignals RS durchgeführt werden. Selbst bei stärkerer Drift des Offset-Wertes würde eine derartige Offset-Messung und -Speicherung in größeren Abständen als in jeder Rechteck-Halbwelle ausreichen.

Verwendet man die in Fig. 1 gezeigte Umformvorrichtung zur empfangsseitigen Verarbeitung eines RDS-Signals in einem Radioempfangsgerät, wird mittels der in Fig. 1 gezeigten Umformvorrichtung das am Empfänger ankommende analoge (etwa sinusförmige) RDS-Signal mittels des Komparators COM in ein Rechtecksignal umgewandelt, das am Ausgang A zur Verfügung steht. Von A aus wird dieses Rechtecksignal einer RDS-PLL-Schaltung zugeführt, mittels welcher empfängerseitig der RDS-Träger wiedergewonnen wird, der auf der Senderseite vor der Aussendung unterdrückt worden ist. Da der wiedergewonnene Träger mittels der RDS-PLL-Schaltung mit dem empfangenen RDS-Signal synchronisiert wird, kann man die Nulldurchgänge des wiedergewonnenen RDS-Trägers als zeitliche Bezugspunkte für die Erzeugung des Verzögerungsimpulses und des Zeitfensterimpulses heranziehen. In diesem Fall erzeugt der Detektor DET bei den Nulldurchgängen des wiedergewonnenen RDS-Trägers jeweils das Detektionssignal, das dann mit Hilfe von MF1 und MF2 zu dem Verzögerungsimpuls bzw. dem Zeitfensterimpuls gemäß Fig. 4 führt.

## Patentansprüche

1. Analogsignal-Rechtecksignal-Umformvorrichtung zur schwellenwertabhängigen Umformung eines analogen Eingangssignals in ein Rechtecksignal;
a) mit einer offset-behafteten Umformschaltung (COM) mit einem Signaleingang (SE), dem das analoge Eingangssignal (AS) zuführbar ist, einem Referenzeingang (RE), dem eine die Umformschwelle bestimmende Referenzspannung zuführbar ist, und einem Signalausgang (CA), von dem das Rechtecksignal (RS) abnehmbar ist;
b) mit einer Offset-Speichereinrichtung (C), die mit dem Signaleingang (SE) der Umformschaltung (COM) verbunden ist und in der eine der Offsetspannung der Umformschaltung (COM) entsprechende Ladespannung speicherbar ist, die dem analogen Eingangssignal zur Offset-Kompensation überlagerbar ist;
c) mit einer steuerbaren Schaltereinrichtung (S), welche in einem ersten Schaltzustand die Umformfunktionsweise der Umformschaltung (COM) unbeeinflußt läßt und zum Zweck der Offset-Kompensation in einem zweiten Schaltzustand den Umformvorgang der Umformschaltung (COM) unterbricht und eine Aufladung der Offset-Speicher-Einrichtung (C) auf die der jeweiligen Offset-Spannung entsprechende Ladespannung bewirkt;
d) mit einer Detektoreinrichtung (DET), mittels welcher mindestens näherungsweise zu denjenigen Zeitpunkten ein Detektionssignal erzeugbar ist, zu welchen das analoge Eingangssignal (AS) einen vorbestimmten Detektionsschwellenwert durchläuft;
e) mit einer Verzögerungseinrichtung (MF1) mittels welcher das Detektionssignal um eine vorbestimmte Verzögerungszeitdauer (TD) verzögerbar ist;
f) und mit einer Schaltersteueranordnung (MF2, SSE), mittels welcher beim Auftreten des verzögerten Detektionssignals die Schaltereinrichtung (S) für eine vorbestimmte Fensterzeitdauer (TF) in den zweiten Schaltzustand steuerbar ist;
g) wobei die Fensterdauer (TF) zwischen den Flanken des Rechtecksignals (RS) liegt.

2. Umformvorrichtung nach Anspruch 1, bei welcher
a) die Umformschaltung einen offset-behafteten Komparator (COM) aufweist; und
b) die Schaltereinrichtung einen zwischen den Signaleingang (SE) und den Signalausgang (CA) des Komparators (COM) geschalteten Schalter (S) aufweist, der im ersten Schaltzustand nicht-leitend und im zweiten Schaltzustand leitend gesteuert ist.

3. Umformvorrichtung nach Anspruch 2, bei welcher ein CMOS-Komparator vorgesehen ist.

4. Umformvorrichtung nach einem der Ansprüche 1 bis 3, bei welcher die Offset-Speicherkapazität durch einen zwischen die Signalquelle (AMP) und den Signaleingang (SE) der Umformschaltung (COM) geschalteten Kondensator (C) gebildet ist.

5. Umformvorrichtung nach einem der Ansprüche 1 bis 4, bei welcher zwischen den Ausgang (CA) der Umformschaltung (COM) und einen das Rechtecksignal erhaltenden Verbraucher eine Zwischenspeicherschaltung (SH) geschaltet ist, mittels welcher der vor Beginn der Fensterdauer (TF) auftretende Signalwert des Rechtecksignals (RS) während der Fensterdauer (TF) zwischenspeicherbar und an den Verbraucher lieferbar ist.

6. Umformvorrichtung nach einem der Ansprüche 1 bis 5, bei welcher die Verzögerungseinrichtung eine erste monostabile Kippschaltung (MF1) aufweist, deren Eingang das Detektionssignal zuführbar ist und die auf das Detektionssignal hin einen Verzögerungsimpuls mit einer der Verzögerungszeitdauer (TD) entsprechenden Impulsdauer erzeugt.

7. Umformvorrichtung nach Anspruch 6, bei welcher eine zweite monostabile Kippschaltung (MF2) vorgesehen ist, deren Eingang mit dem Ausgang der ersten monostabilen Kippschaltung (MF1) verbunden ist und die auf das Auftreten der Endflanke des Verzögerungsimpulses hin einen Zeitfensterimpuls mit einer der Fensterzeitdauer (TF) entsprechenden Impulsdauer erzeugt, wobei die Schaltereinrichtung (S) während der Dauer des Zeitfensterimpulses in den zweiten Schaltzustand steuerbar ist.

8. RDS-Empfangsschaltung mit
a) einer Umformschaltung nach einem der Ansprüche 1 bis 7 zur Umformung eines empfangenen analogen RDS-Signals in ein RDS-Rechtecksignal;
b) und einer der Umformschaltung nachgeschalteten RDS-PLL-Schaltung zur empfängerseitigen Wiedergewinnung des senderseitig unterdrückten RDS-Trägers;
c) wobei mittels der Detektionseinrichtung (DET) die Nulldurchgänge des wiedergewonnenen RDS-Signals detektierbar sind.

9. Pulsbreitenmodulationsschaltung mit einer Umformschaltung nach einem der Ansprüche 1 bis 7.
